# EUROPÄISCHE PATENTSCHRIFT

(11) **EP 0 821 479 B1**
(45) Veröffentlichungstag und Bekanntmachung des Hinweises auf die Patenterteilung: **21.05.2003**
(21) Anmeldenummer: 97112880.6
(22) Anmeldetag: 25.07.1997
(51) Int. Cl.: H03G 5/00, H03G 5/02

(54) **Filterschaltung und damit ausgerüsteter Audiosignalprozessor**
Filter circuit and audio signal processor comprising the same
Circuit de filtre et processeur à signaux acoustiques comprenant ce filtre

(30) Priorität: 26.07.1996 DE 19630406
(43) Veröffentlichungstag der Anmeldung: 28.01.1998
(73) Patentinhaber: SGS-THOMSON MICROELECTRONICS GMBH, 85630 Grasbrunn (DE)
(72) Erfinder: Kirchlechner, Peter, 83104 Hohenthann (DE); Schambacher, Jörg, 81677 München (DE); Lübbe, Jürgen, 83553 Jacobneuharting (DE)
(74) Vertreter: Hirsch, Peter, Dipl.-Ing.

(56) Entgegenhaltungen:
- GB-A- 2 116 388
- GB-A- 2 138 231
- US-A- 4 453 143
- US-A- 5 331 218
- PATENT ABSTRACTS OF JAPAN vol. 017, no. 422 (P-1586), 5. August 1993 (1993-08-05) & JP 05 081364 A (FUJITSU LTD), 2. April 1993 (1993-04-02)

## Beschreibung

Die Erfindung betrifft eine Filterschaltung sowie einen damit ausgerüsteten Audiosignalprozessor.

Bei Geräten aus dem Bereich der Unterhaltungselektronik, wie beispielsweise Rundfunkempfangsgeräten, Kassettenrecordern, CD-Abspielgeräten u.ä. ist es üblich, im Audio-Signalpfad einstellbare Filterschaltungen vorzusehen, mit denen der Benutzer gewisse Klangcharakteristika wie beispielsweise Höhenanhebung und Höhenbedämpfung oder Bassanhebung und Bassbedämfung beeinflussen kann. Die Einstellung geeigneter Filterkennwerte erfolgt durch den Bediener mittels dafür vorgesehener Bedienelemente. Die einstellbaren Filterschaltungen sind dabei für Zwecke der Audiosignalbeeinflussung in Geräten der Unterhaltungselektronik regelmäßig derart ausgelegt, daß sie insbesondere auch eine neutrale Einstellung ermöglichen, in welcher sie die Audiosignale hinsichtlich Frequenz- und Phasengang möglichst wenig beeinflussen. Wenn der Bediener keinerlei Anhebung oder Absenkung von bestimmten Frequenzbereichen des Audiosignals wünscht, wird er diese neutrale Einstellung der jeweiligen Filterschaltung wählen.

Im Hinblick auf zahlreiche der Unterhaltungselektronik zuzurechnende Geräte, so zum Beispiel bei kompakten Rundfunkempfangsgeräten, wie sie insbesondere bei der Ausrüstung von Kraftfahrzeugen Verwendung finden, ist seit langem ein Trend zu beobachten, zur Kostensenkung bei der Herstellung die gesamte elektrische Schaltung des Empfängers aus möglichst wenigen hochintegrierten elektronischen Bausteinen zusammenzufügen.

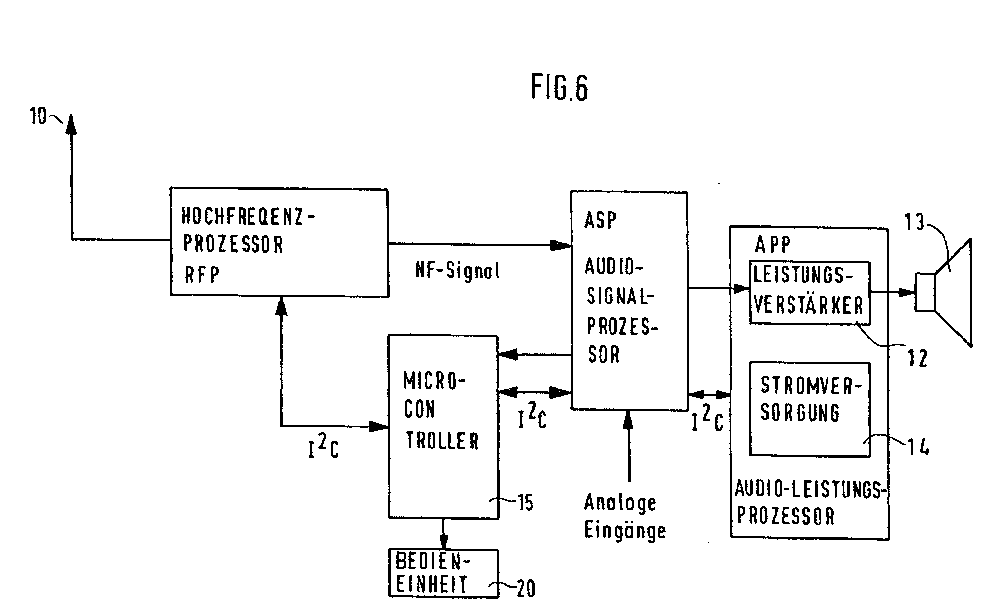

**Fig. 6** zeigt ein Blockschaltbild eines Rundfunkempfangsgeräts nach dem Stand der Technik. Die von einer Hochfrequenzantenne 10 gelieferten Hochfrequenzsignale werden einem Hochfrequenz-Empfangsteil, im folgenden "Hochfrequenzprozessor" RFP genannt, zugeführt. Der Hochfrequenzprozessor RFP beinhaltet Hochfrequenz-Vorstufen, Tuner, Zwischenfrequenzverstärker und -Filter sowie Demodulatoren. Ein das Nutzsignal des empfangenen Senders darstellendes Niederfrequenzsignal wird einem Audiosignalprozessor ASP zugeführt. Dieses Niederfrequenzsignal umfaßt nicht nur das demodulierte Audiosignal, sondern auch Hilfssignale für Stereo-Empfang, ARI-Kennung, RDS und andere.

Der Audiosignalprozessor ASP setzt insbesondere das vom Hochfrequenzprozessor RFP gelieferte Niederfrequenzsignal in Audiosignale um, die einem Audio-Leistungsprozessor APP zugeführt werden. Der Audio-Leistungsprozessor APP umfaßt insbesondere einen Leistungsverstärker 12, der die vom Audio-Signalprozessor ASP gelieferten Ausgangssignale soweit verstärkt, daß sie durch Lautsprecher 13 wiedergegeben werden können. Ferner umfaßt der Audio-Leistungsprozessor APP ein Spannungsreglermodul 14 zur Stromversorgung.

Dem Audiosignalprozessor ASP können über weitere analoge Eingänge andere Audiosignale, beispielsweise von Kassettenrecordern, CD-Abspielgeräten o. dgl., zugespeist werden.

Das beschriebene Rundfunkempfangsgerät wird als Ganzes durch einen Mikrocontroller 15, der mit einer dem Bediener zugänglichen Bedieneinheit 20 verbunden ist, gesteuert. Der Datenaustausch zwischen dem Mikrocontroller 15 einerseits und dem Hochfrequenzprozessor RFP, dem Audiosignalprozessor ASP und dem Audio-Leistungsprozessor APP andererseits erfolgt durch einen herkömmlichen I²C-Bus.

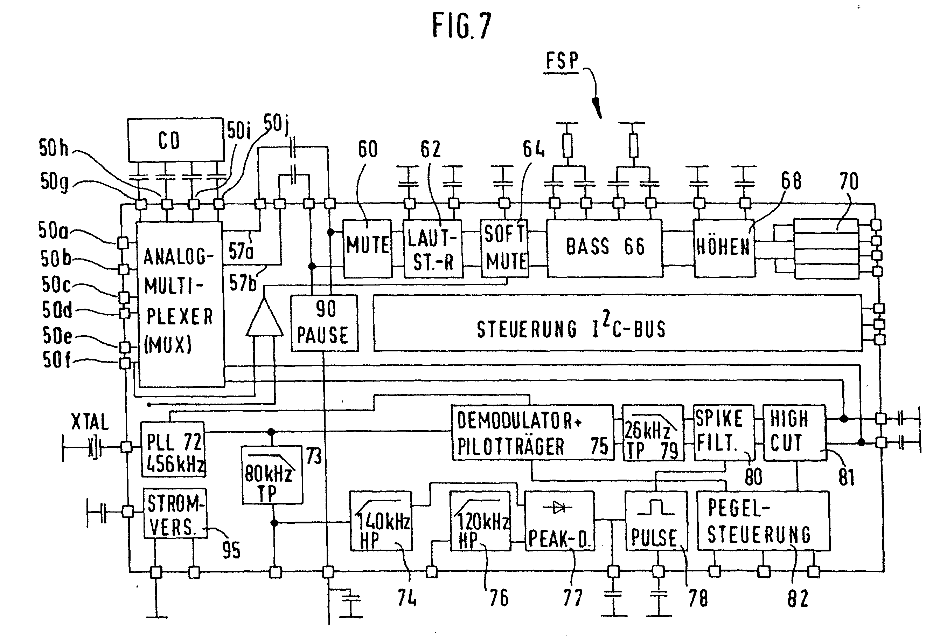

**Fig. 7** zeigt ein schematisches Blockschaltbild des Audiosignalprozessors ASP des in **Fig. 6** dargestellten Rundfunkempfängers. Der Audiosignalprozessor ASP weist eine Anzahl von analogen Audiosignaleingängen 50a bis 50j auf, die mit entsprechenden Eingangsleitungen eines Analog-Multiplexers 55 verbunden sind. Ein Stereo-Ausgangssignal des Analog-Multiplexers 55 wird über Ausgangsleitungen 57a und 57b einer Kette aus hintereinander geschalteten und als Signalbehandlungsvorrichtungen wirkenden Blöcken 60, 62, 64, 66, 68 zugespeist.

Zunächst gelangen die Audiosignale in ein Stummschaltungsfilter ("Mute") 60, danach nacheinander in einen Lautstärkeregler mit Loudness-Filter 62, in eine zweite Stummschaltungsanordnung mit weicher Stummschaltungseigenschaft ("Soft Mute") 64, einen Tiefenregler ("Bass") 66 sowie einem Höhenregler 68 ("Treble"). Danach werden die Stereo-Audiosignale einer Anzahl von Audiotreiberverstärkern 70 zugespeist, wo sie soweit konditioniert werden, daß sie für die Ansteuerung der Leistungsendstufen im Leistungsverstärker 12 innerhalb des Audio-Leistungsprozessors APP geeignet sind.

Dabei wird jeder Kanal des Stereosignals in einen ersten Unterkanal für einen vorn in der Fahrgastzelle anzubringenden ersten Lautsprecher und einen zweiten Unterkanal für einen hinten im Fahrgastraum anzubringenden zweiten Lautsprecher aufgeteilt.

Ferner weist der Audiosignalprozessor ASP eine Reihe von üblichen Funktionsblöcken 72 bis 82 auf, die zur Verarbeitung des Stereo-Differenzsignals, des ARI-Signals usw. erforderlich sind. Schließlich ist eine Pausenschaltung 90 und eine Stromversorgungseinrichtung 95 vorgesehen.

Dem Fachmann ist deutlich, daß der in den **Fign. 6** und **7** wiedergegebene integrierte Audiosignalprozessor ASP nicht die einzig mögliche Ausführungsform eines solchen Prozessors darstellt. Insbesondere kann der Audiosignalprozessor auch ohne die Funktionseinheiten zur Behandlung von FM-Stereosignalen implementiert sein. Auch die Art und Anzahl der NF-Stufen zur Beeinflussung des Audiosignals kann im Einzelfall variieren.

Die vorstehend beschriebene Schaltung weist den Nachteil auf, daß eine vollständige Integration der Audiofilter 62, 66, 68 nicht gegeben ist, da zahlreiche RC-Glieder mit hohen Widerstandswerten und/oder Kapazitätswerten wegen zu großen Chipflächenbedarfes der Widerstände R bzw. Kapazitäten C mittels externer Bauelemente realisiert sind.

Aus der Druckschrift GB-A-2,138,231 ist eine Signalübertragungsschaltung mit MOS-Schaltern bekannt. Diese Schaltung weist durch die MOS-Schalter schaltbare Kondensatoren sowie einen Operationsverstärker auf. Das Schalten der MOS-Schalter erfolgt unter Steuerung des Ausgangssignals eines spannungsgesteuerten Oszillators, dessen Ausgangsfrequenz mit Hilfe einer variablen Spannungsquelle veränderbar ist, womit die Übertragungscharakteristik der bekannten Signalübertragungsschaltung einstellbar ist. Bei einer ebenfalls aus der Druckschrift GB-A-2,138,231 bekannten anderen Schaltung befindet sich im Rückkopplungsweg des Operationsverstärkers eine Parallelschaltung mit einem Rückkopplungswiderstand und einem SC-Filter. In einem ersten Betriebsmodus befindet sich das SC-Filter im Rückkopplungskreis, wohingegen es bei einem zweiten Betriebszustand nicht im Rückkopplungskreis wirksam ist.

Aus der Druckschrift US-A-4,453,143 ist ein Equalizer mit einem Filter und einem summierenden Verstärker bekannt. Sowohl der summierende Verstärker als auch das Filter enthalten geschaltete Kondensatoren. Der summierende Verstärker weist einen Operationsverstärker auf, in dessen Rückkopplungskreis sich jedoch keinerlei Filter befinden.

Aus der Buchveröffentlichung von Hans Eigler: "Mikroelektronische Filter", Berlin: Verlag Technik GmbH, 1. Auflage 1990, Seiten 72-83, sind die Grundlagen für SC-Filter bekannt.

US-A-5331 218 offenbart weitere Filterschaltungen, die SC-Technik verwenden.

Aufgabe der Erfindung ist es daher, eine Filterschaltung sowie einen mit dieser versehenenen Audiosignalprozessor vorzusehen, die die Nachteile bei dem Stand der Technik nicht aufweisen und die insbesondere leicht vollständig integrierbar sind.

Diese Aufgabe wird erfindungsgemäß gelöst durch eine Filterschaltung mit den in Anspruch 1 angegebenen Merkmalen. Sie wird ferner auch gelöst durch einen Audiosignalprozessor gemäß den in dem Patentanspruch 9 angegebenen Merkmalen. Weitere Verbesserungen der Gegenstände dieser Patentansprüche sind den Unteransprüchen zu entnehmen.

Im folgenden wird die Erfindung in Gestalt von exemplarischen Ausführungsbeispielen anhand der Zeichnung näher erläutert:
- **Fig. 1**: zeigt ein Blockschaltbild eines erfindungsgemäßen, in SC-Technik ausgeführten einstellbaren Audio-Filters.
- **Fig. 2**: zeigt in **Fig. 2a** eine Schemadarstellung eines als geschalteter Kondensator ausgeführten Widerstandselementes 200 und in **Fig. 2b** ein Äquivalentschaltbild dieses Widerstandselementes 200. **Fig. 2c** zeigt eine exemplarische Implementation einer Umschalteinrichtung aus **Fig. 2b** unter Verwendung von zwei MOS-Transistoren. **Fig. 2d** zeigt überlappungsfreie Taktsignale.
- **Fig. 3**: zeigt ein Schaltungsdiagramm einer ersten Ausführungsform des SC-Filtermoduls aus **Fig. 1,** nämlich für ein Loudness-Filter.
- **Fig. 4**: zeigt ein Schaltungsdiagramm einer zweiten Ausführungsform des SC-Filtermoduls aus **Fig. 1,** nämlich für ein Bass-Filter.
- **Fig. 5**: zeigt ein Schaltungsdiagramm einer dritten Ausführungsform des SC-Filtermoduls aus **Fig. 1,** nämlich für ein Treble-Filter.
- **Fig. 6**: zeigt ein schematisches Blockschaltbild eines Rundfünkempfangsgerätes nach dem Stand der Technik.
- **Fig. 7**: zeigt ein schematisches Blockschaltbild des Audiosignalprozessors des Rundfunkempfangsgerätes aus **Fig. 6** mit einiger peripherer Beschaltung.

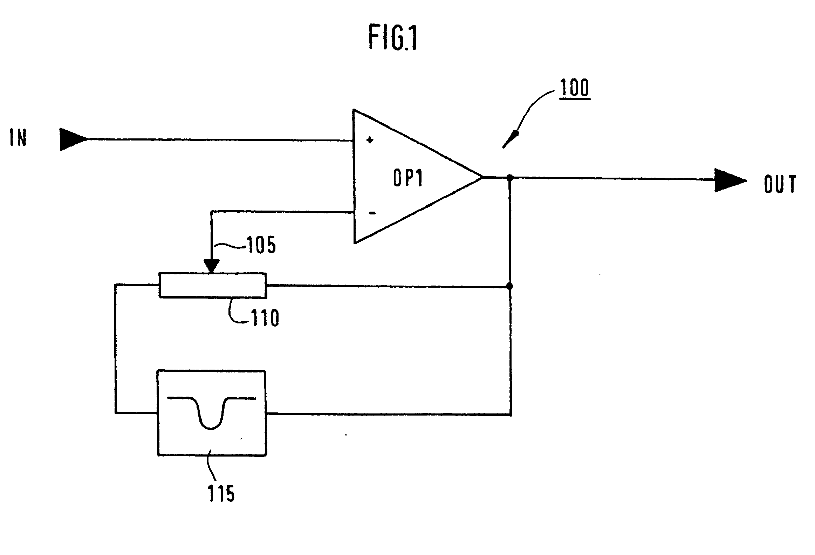

**Fig. 1** zeigt ein Blockschaltbild eines erfindungsgemäßen, in SC-Technik ausgeführten einstellbaren Audio-Filters, das insbesondere zum Einsatz in einem Audiosignalprozessor ASP geeignet ist, wie er beispielsweise in **Fig. 7** veranschaulicht wird. Die in **Fig. 1** dargestellte Schaltung ist dann insbesondere zur Implementation des Loudness-Filters 62, des Bass-Filters 66 sowie des Treble-Filters 68 geeignet.

Die Schaltung weist einen Eingang IN, der mit dem nicht invertierenden Eingang eines Operationsverstärkers OP1 verbunden ist, sowie einen Ausgang OUT, der mit dessen Ausgang verbunden ist, auf. Der invertierende Eingang des Operationsverstärkers OP1 ist mit dem Abgriff 105 eines zwischen den Ausgang des Operationsverstärkers OP1 und den Ausgang eines in SC-Technik realisierten Filtermoduls 115 geschalteten ohmschen Spannungsteilers 110 verbunden. Der Eingang des Filtermoduls 115 ist mit dem Ausgang des Operationsverstärkers OP1 verbunden.

Die Einstellung des Abgriffes 105 des ohmschen Spannungsteilers 110 bestimmt die Wirksamkeit der in **Fig. 1** dargestellten Filterschaltung. Wird der Abgriff 105 des ohmschen Spannungsteilers 110 so eingestellt, daß er unmittelbar mit dem Ausgang des Operationsverstärkers OP1 kurzgeschlossen ist, so verhält sich die in **Fig. 1** dargestellte Schaltung wie ein Spannungsfolger mit dem Verstärkungsfaktor gleich Eins. Das Filtermodul 115 liegt nicht im Signalpfad. In diesem Fall befindet sich das Filter in seiner neutralen Einstellung, und das Filtermodul 115 speist keinerlei Rauschspannungen in das Audio-Ausgangssignal an der Ausgangsklemme OUT ein und verursacht auch keine Signalverzerrungen.

In dem Maße, in dem der Abgriff 105 des ohmschen Spannungsteilers 110 in seiner Einstellung so verändert wird, daß ein Teilwiderstand zwischen dem Ausgang des Operationsverstärkers OP1 und dem Abgriff 105 wirksam wird, gerät das Filtermodul 115 in den Signalpfad und beeinflußt die Frequenzcharakteristik des Filters.

Dabei wird das Ausgangssignal am Ausgangsanschluß des Operationsverstärkers OP1 über das Filtermodul 115 sowie über den Spannungsteiler 110 auf den invertierenden Eingang des Operationsverstärkers OP1 gegengekoppelt.

Der ohmsche Spannungsteiler 110 kann als herkömmliches Potentiometer ausgeführt werden. Bei einem Einsatz in einer integrierten Schaltung erweist es sich jedoch als vorteilhaft, den ohmschen Spannungsteiler 110 beispielsweise als mit MOS-Schaltern geschaltete Widerstandskette auszuführen. Beim Einsatz der Filterschaltung nach **Fig. 1** in einem Audiosignalprozessor ASP (wie beispielsweise in **Fig. 7** dargestellt) besteht dann die Möglichkeit, den ohmschen Spannungsteiler 110 durch eine digitale Einstelleinrichtung z.B. über den I²C - Bus einzustellen.

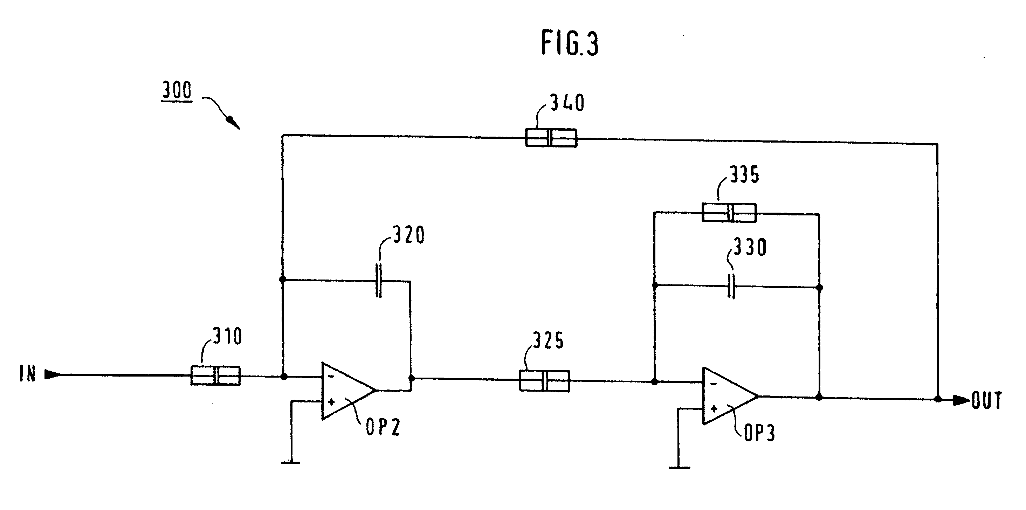

**Fig. 2a** zeigt eine schematische Darstellung eines mit einem geschalteten Kondensator implementierten Widerstandselementes 200, wie es in den in den **Fign. 3** bis **5** dargestellten Ausführungsformen verwendet wird.

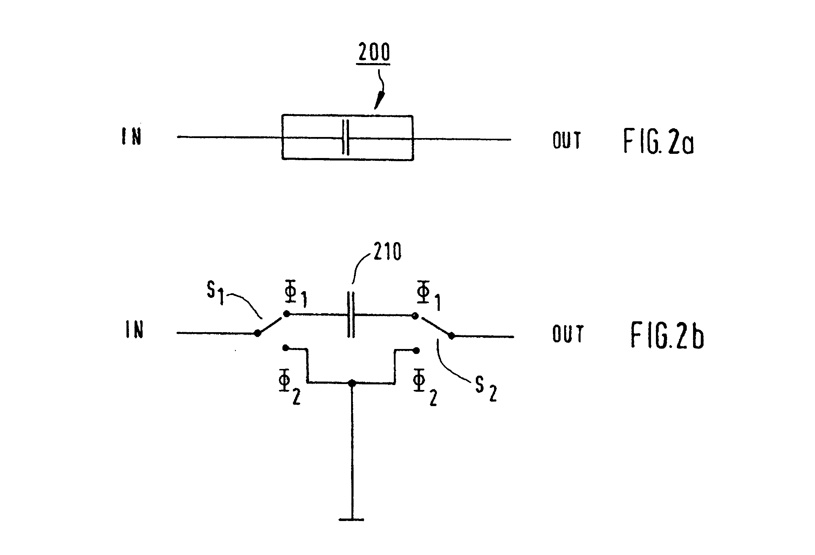

**Fig. 2b** zeigt ein elektrisches Äquivalentschaltbild des in **Fig. 2a** dargestellten Widerstandselementes 200. Der Eingang IN der Schaltung kann über eine erste Umschalteinrichtung S1 mit einem ersten Anschluß eines Kondensators 210 oder aber mit Masse verbunden werden. Der Ausgangsanschluß OUT kann über eine zweite Umschalteinrichtung S2 mit einem zweiten Anschluß des Kondensators 210 oder mit Masse verbunden werden. Wenn die Umschalteinrichtungen S1, S2 nicht angesteuert sind, sind sie elektrisch offen.

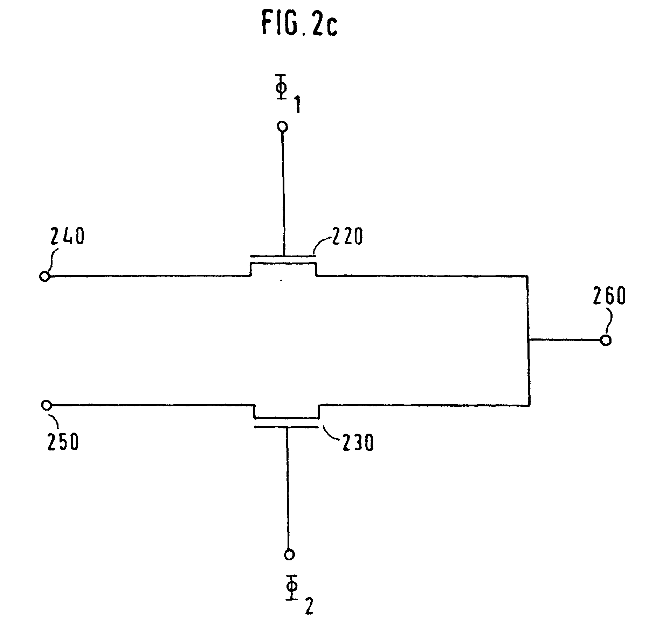

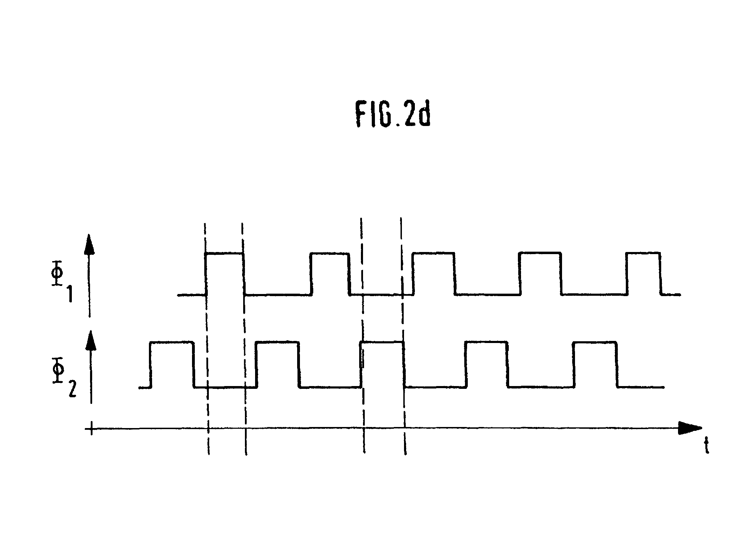

**Fig. 2c** zeigt eine exemplarische Implementation einer Umschalteinrichtung S1, S2 aus **Fig. 2b** unter Verwendung von zwei MOS-Transistoren 220, 230. Ein erster MOS-Transistor 220 verbindet über seine Source-Drain-Strecke einen gemeinsamen Anschluß 260 mit einem ersten Umschalter-Ausgangsanschluß 240, wohingegen ein zweiter MOS-Transistor 230 über seine Source-Drain-Strecke den gemeinsamen Anschluß 260 mit einem zweiten Umschalter-Ausgangsanschluß 250 verbindet. Das Gate des ersten MOS-Transistors 220 ist an das Taktsignal Φ₁ angeschlossen, wohingegen das Gate des zweiten MOS-Transistors 230 an das Taktsignal Φ₂ angeschlossen ist. **Fig. 2d** zeigt Taktsignale Φ₁, Φ₂ zur Ansteuerung der Umschalteinrichtungen S1, S2 in **Fig. 2b** bzw. der MOS-Transistoren 220, 230 in **Fig. 2c.** Wie in der SC-Technik üblich, sind die beiden Taktphasen Φ₁, Φ₂ derart ausgestaltet, daß sich ihre hochpegeligen (aktiven) Intervalle zu keinem Zeitpunkt überlappen. Dadurch wird erreicht, daß in der Schaltung nach **Fig. 2c** stets nur ein einziger der beiden MOS-Transistoren 220, 230 leitet und somit der gemeinsame Anschluß 260 elektrisch offen oder entweder mit dem ersten Umschalteranschluß 240 oder mit dem zweiten Umschalteranschluß 250, nie jedoch mit beiden gleichzeitig, verbunden ist.

**Fig. 3** zeigt ein elektrisches Schaltungsdiagramm einer ersten Ausführungsform 300 eines Filtermoduls 115, nämlich für ein Loudness-Filter. Die Schaltung verkörpert einen Tiefpaß II. Ordnung und ist in SC-Technik ausgeführt.

Ein Eingangsanschluß IN ist über einen ersten in SC-Technik ausgeführten Widerstand 310 mit dem invertierenden Eingang eines Operationsverstärkers OP2 verbunden. Der nicht-invertierende Eingang des Operationsverstärkers OP2 ist mit Masse verbunden.

Der Ausgang des Operationsverstärkers OP2 ist über eine Kapazität 320 mit dessen invertierenden Eingang verbunden. Der invertierende Eingang eines weiteren Operationsverstärkers OP3 ist über einen zweiten in SC-Technik ausgeführten Widerstand 325 mit dem Ausgang des Operationsverstärkers OP2 verbunden. Der nicht-invertierende Eingang des Operationsverstärkers OP3 ist ebenfalls mit Masse verbunden.

Der Ausgang des Operationsverstärkers OP3 ist über einen dritten Kondensator 330 mit dessen invertierenden Eingang verbunden. Parallel zu der dritten Kapazität 330 ist ein dritter in SC-Technik ausgeführter Widerstand 335 geschaltet. Ein vierter in SC-Technik ausgeführter Widerstand 340 verbindet den invertierenden Eingang des Operationsverstärkers OP2 mit dem Ausgang des Operationsverstärkers OP3.

Der Ausgang des Operationsverstärkers OP3 ist mit einem Ausgang OUT verbunden.

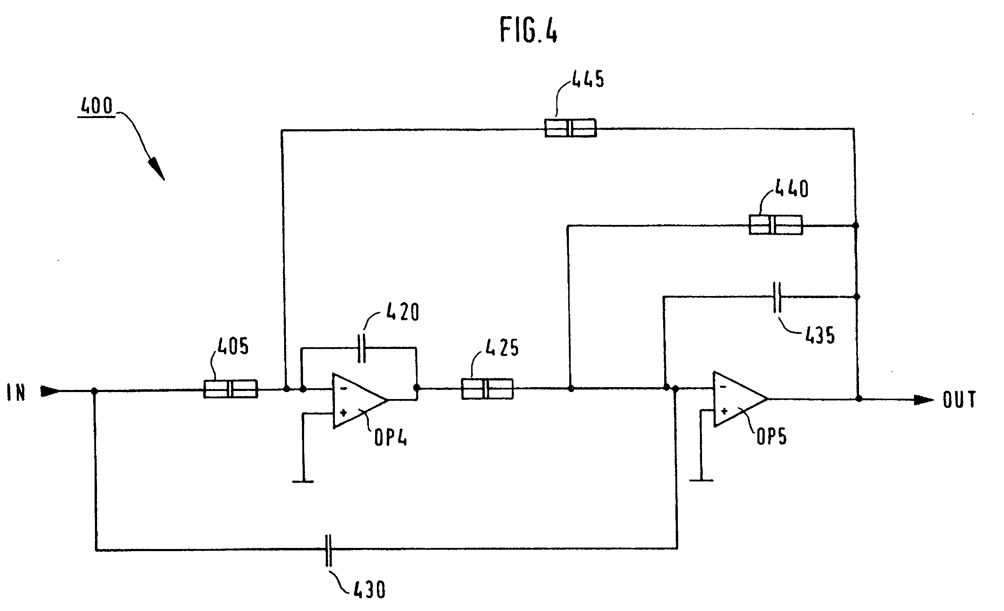

**Fig. 4** zeigt ein elektrisches Schaltungsdiagramm einer zweiten Ausführungsform 400 eines Filtermoduls 115. Die in **Fig. 4** dargestellte Schaltung kommt in einem Bass-Filter zum Einsatz.

Der invertierende Eingang eines Operationsverstärkers OP4 ist über einen ersten in SC-Technik ausgeführten Widerstand 405 mit einem Eingang IN verbunden. Der Ausgang des Operationsverstärkers OP4 ist über eine erste Filterkapazität 420 mit dessen invertierendem Eingang verbunden. Der invertierende Eingang eines weiteren Operationsverstärkers OP5 ist über einen zweiten in SC-Technik ausgeführten Widerstand 425 mit dem Ausgang des Operationsverstärkers OP4 verbunden. Der invertierende Eingang des Operationsverstärkers OP5 ist außerdem über eine zweite Filterkapazität 430 mit dem Eingang IN sowie über eine dritte Filterkapazität 435 mit dessen Ausgang verbunden. Schließlich ist der invertierende Eingang des Operationsverstärkers OP5 über einen dritten in SC-Technik ausgeführten Widerstand 440 mit dessen Ausgang verbunden. Der Ausgang des Operationsverstärkers OP5 ist über einen vierten in SC-Technik ausgeführten Widerstand 445 mit dem invertierenden Eingang des Operationsverstärkers OP4 verbunden.

Der nicht mit dem invertierenden Eingang des Operationsverstärkers OP5 verbundene Anschluß des dritten in SC-Technik ausgeführten Widerstandes 440 sowie der nicht mit dem invertierenden Eingang des Operationsverstärkers OP5 verbundene Anschluß der dritten Filterkapazität 435 sind miteinander verbunden. Der Ausgang des Operationsverstärkers OP5 ist mit dem Ausgangsanschluß OUT verbunden. Der nicht-invertierende Eingänge der Operationsverstärker OP4 bzw. OP5 sind jeweils mit Bezugspotential (Masse) verbunden.

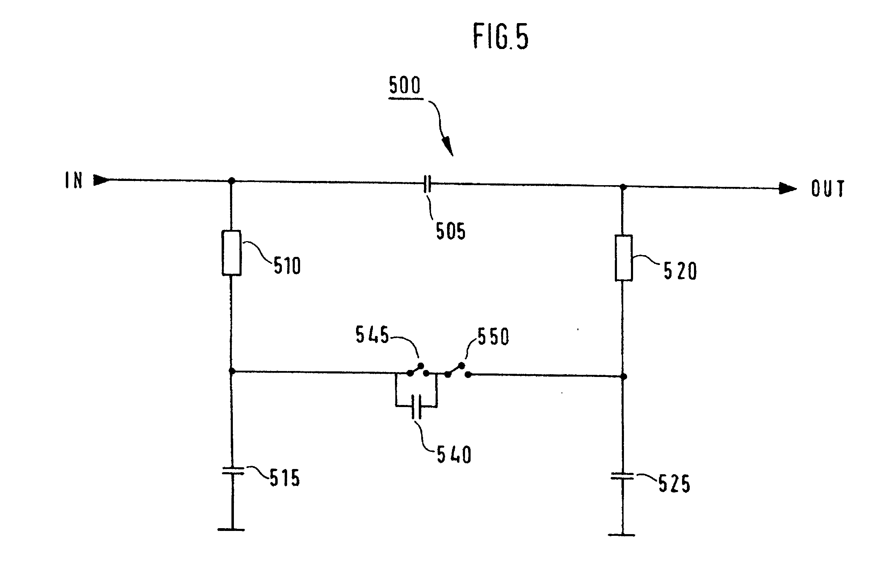

**Fig. 5** zeigt ein elektrisches Schaltungsdiagramm einer dritten Ausführungsform 500 eines Filtermoduls 115, nämlich für ein Treble-Filter.

Ein Eingang IN ist über eine erste Kapazität 505 mit einem Ausgang OUT verbunden. Des weiteren ist der Eingang IN über einen ersten Widerstand 510 und eine zweite Kapazität 515 an Masse geschaltet. Der Ausgangsanschluß OUT ist über einen zweiten Widerstand 520 und eine dritte Kapazität 525 ebenfalls an Masse geschaltet. Die Kopplungspunkte zwischen dem Widerstand 510 und der Kapazität 515 sowie dem Widerstand 520 und der Kapazität 525 sind über einen in SC-Technik ausgeführten Widerstand 530 miteinander verbunden.

## Patentansprüche

1. Filterschaltung zum einstellbaren Absenken oder Anheben der Amplitude von Audiosignalen in einem vorbestimmten Frequenzbereich,
a) mit einem Eingang (IN) und einem Ausgang (OUT),
b) mit einem ersten Operationsverstärker (OP1), wobei der nicht-invertierende Eingang des ersten Operationsverstärkers (OP1) mit dem Eingang (IN) verbunden ist,
c) mit einem ohmschen Spannungsteiler (110) als Einstelleinrichtung, dessen Abgriff (105) mit dem invertierenden Eingang des ersten Operationsverstärkers (OP1) verbunden ist und dessen erster Endanschluß mit dem Ausgang des ersten Operationsverstärkers (OP1) verbunden ist,
d) mit einem Filtermodul (115), wobei das Filtermodul ein RC-Netzwerk mit mindestens einem frequenzgangbestimmenden RC-Glied aufweist, dessen Widerstandskomponente R in SC-Technik realisiert ist,
e) wobei der Eingang des Filtermoduls (115) mit dem Ausgang des ersten Operationsverstärkers (OP1) verbunden ist, und
f) wobei der Ausgang des Filtermoduls (115) mit einem zweiten Endanschluß des ohmschen Spannungsteilters (110) direkt verbunden ist.

2. Filterschaltung nach Anspruch 1, **dadurch gekennzeichnet, daß** die Einstelleinrichtung (110) ein Potentiometer aufweist.

3. Filterschaltung nach Anspruch 1, **dadurch gekennzeichnet, daß** die Einstelleinrichtung (110) mit einem einen oder mehrere Transistoren aufweisenden Spannungsteiler versehen ist.

4. Filterschaltung nach einem der vorstehenden Ansprüche, **dadurch gekennzeichnet, daß** das Filtermodul (115) ein Biquad-Filter aufweist.

5. Filterschaltung nach Anspruch 4, **dadurch gekennzeichnet, daß** das Filtermodul (115) aufweist:
a) einen zweiten Operationsverstärker (OP4),
b) einen dritten Operationsverstärker (OP5),
c) ein erstes SC-Widerstandselement (405),
d) ein zweites SC-Widerstandselement (425),
e) ein drittes SC-Widerstandselement (440),
f) ein viertes SC-Widerstandselement (445),
g) eine erste Filterkapazität (420),
h) eine zweite Filterkapazität (430),
i) eine dritte Filterkapazität (435),
j) wobei der nicht-invertierende Eingang des zweiten Operationsverstärkers (OP4) sowie der nicht-invertierende Eingang des dritten Operationsverstärkers (OP5) auf einem Bezugspotential liegen,
k) wobei der Eingang des Filtermoduls (115) über das erste SC-Widerstandselement (405) mit dem invertierenden Eingang des zweiten Operationsverstärkers (OP4) verbunden ist,
l) wobei der Ausgang des Filtermoduls (115) mit dem Ausgang des dritten Operationsverstärkers (OP5) verbunden ist,
m) wobei der invertierende Eingang des dritten Operationsverstärkers (OP5) über die zweite Filterkapazität (430) mit dem Eingang des Filtermoduls (115) verbunden ist,
n) wobei der Ausgang des zweiten Operationsverstärkers (OP4) über die erste Filterkapazität (420) mit dem invertierenden Eingang des zweiten Operationsverstärkers (OP4) verbunden ist,
o) wobei der Ausgang des zweiten Operationsverstärkers (OP4) über das zweite SC-Widerstandselement (425) mit dem invertierenden Eingang des dritten Operationsverstärkers (OP5) verbunden ist,
p) wobei der invertierende Eingang des dritten Operationsverstärkers (OP5) über das dritte SC-Widerstandselement (440) mit dem Ausgang des dritten Operationsverstärkers (OP5) verbunden ist,
q) wobei der invertierende Eingang des zweiten Operationsverstärkers (OP4) über das vierte SC-Widerstandselement (445) mit dem Ausgang des dritten Operationsverstärkers (OP5) verbunden ist, und wobei
r) der invertierende Eingang des dritten Operationsverstärkers (OP5) über die dritte Filterkapazität (435) mit dem Ausgang des dritten Operationsverstärkers (OP5) verbunden ist.

6. Filterschaltung nach einem der Ansprüche 1 bis 3, **dadurch gekennzeichnet, daß** das Filtermodul (115) aufweist:
a) eine erste, zweite und dritte Kapazität (505, 515 bzw. 525),
b) einen ersten und einen zweiten Widerstand (510 bzw. 520),
c) ein SC-Widerstandselement (540, 545, 550),
d) wobei der Eingang (IN) des Filtermoduls (115) über die erste Kapazität (505) mit dem Ausgang (OUT) des Filtermoduls (115) verbunden ist,
e) wobei der Eingang (IN) des Filtermoduls (115) über den ersten Widerstand (510) und die zweite Kapazität (515) mit dem Bezugspotential verbunden ist,
f) wobei der Ausgang (OUT) des Filtermoduls (115) über den zweiten Widerstand (520) und die dritte Kapazität (525) mit dem Bezugspotential verbunden sind,
g) wobei der Schaltungsknoten zwischen dem ersten Widerstand (510) und der zweiten Kapazität (515) über das SC-Widerstandselement (540, 545, 550) mit dem Schaltungsknoten zwischen dem zweiten Widerstand (520) und der dritten Kapazität (525) verbunden ist.

7. Filterschaltung nach Anspruch 6, **dadurch gekennzeichnet, daß** das SC-Widerstandselement (530) einen geschalteten Kondensator (540), eine erste Schalteinrichtung (545) und eine zweite Schalteinrichtung (550) aufweist, wobei die erste Schalteinrichtung (545) im leitenden Zustand den geschalteten Kondensator (540) entlädt und wobei die zweite Schalteinrichtung (550) im nichtleitenden Zustand einen Anschluß des geschalteten Kondensators (540) elektrisch von der Umgebung trennt.

8. Filterschaltung nach einem der Ansprüche 1 bis 3, **dadurch gekennzeichnet, daß** das Filtermodul (115) aufweist:
a) einen zweiten Operationsverstärker (OP2),
b) einen dritten Operationsverstärker (OP3),
c) ein erstes SC-Widerstandselement (310),
d) ein zweites SC-Widerstandselement (325),
e) ein drittes SC-Widerstandselement (335),
f) ein viertes SC-Widerstandselement (340),
g) eine erste Filterkapazität (320),
h) eine zweite Filterkapazität (330),
i) wobei der nicht-invertierende Eingang des zweiten Operationsverstärkers (OP2) und der nicht-invertierende Eingang des dritten Operationsverstärkers (OP3) auf einem Bezugspotential liegen,
j) wobei der Eingang (IN) des Filtermoduls (115) über das erste SC-Widerstandselement (310) mit dem invertierenden Eingang des zweiten Operationsverstärkers (OP2) verbunden ist,
k) wobei der Ausgang des zweiten Operationsverstärkers (OP2) über das zweite SC-Widerstandselement (325) mit dem invertierenden Eingang des dritten Operationsverstärkers (OP3) verbunden ist,
l) wobei der Ausgang (OUT) des dritten Operationsverstärkers (OP3) mit dem Ausgang des Filtermoduls (115) verbunden ist,
m) wobei der Ausgang des zweiten Operationsverstärkers (OP2) über die erste Filterkapazität (320) mit dem invertierenden Eingang des zweiten Operationsverstärkers (OP2) verbunden ist,
n) wobei der Ausgang des dritten Operationsverstärkers (OP3) über die zweite Filterkapazität (330) mit dem invertierenden Eingang des dritten Operationsverstärkers (OP3) verbunden ist,
o) wobei der Ausgang des dritten Operationsverstärkers (OP3) über das dritte SC-Widerstandselement (335) mit dem invertierenden Eingang des dritten Operationsverstärkers (OP3) verbunden ist, und wobei
p) der Ausgang des dritten Operationsverstärkers (OP3) über das vierte SC-Widerstandselement (340) mit dem invertierenden Eingang des zweiten Operationsverstärkers (OP2) verbunden ist.

9. Audiosignalprozessor mit
a) mindestens einem Audiosignal-Eingang und mindestens einem Audiosignal-Ausgang sowie mindestens einem Steuereingang, und
b) einer zwischen Audiosignal-Eingang und Audiosignal-Ausgang geschalteten Audiosignalverarbeitungseinheit,
**dadurch gekennzeichnet, daß**
c) die Audiosignalverarbeitungseinheit mindestens eine Filterschaltung gemäß einem der Ansprüche 1 bis 8 aufweist.

10. Audiosignalprozessor nach Anspruch 9, **gekennzeichnet durch**
a) eine mit einer Datensammelleitung verbindbaren digitalen Steuereinheit,
b) wobei die digitale Steuereinheit die Einstellung des ohmschen Spannungsteilers (105) bestimmt.

## Claims

1. A filter circuit for adjustably decreasing or increasing the amplitude of audio signals in a predetermined frequency range, comprising
a) an input (IN) and an output (OUT),
b) a first operational amplifier (OP1), with the non-inverting input of the first operational amplifier (OP1) being connected to said input (IN),
c) an ohmic voltage divider (110) as a setting means, whose tap (105) is connected to the inverting input of the first operational amplifier (OP1) and whose first end terminal is connected to the output of the first operational amplifier (OP1),
d) a filter module (115), said filter module having an RC network with at least one frequency-response-determining RC member whose resistor component R is realized in SC technology,
e) the input of the filter module (115) being connected to the output of the first operational amplifier (OP1), and
f) the output of the filter module (115) being directly connected to a second end terminal of the ohmic voltage divider (110).

2. The filter circuit of claim 1,
**characterized in that** the setting means (110) comprises a potentiometer.

3. The filter circuit of claim 1,
**characterized in that** the setting means (110) is provided with a voltage divider having one or more transistors.

4. The filter circuit of any of the preceding claims,
**characterized in that** the filter module (115) comprises a biquad filter.

5. The filter circuit of claim 4,
**characterized in that** filter module (115) comprises:
a) a second operational amplifier (OP4),
b) a third operational amplifier (OP5),
d) a second SC resistor member (425),
e) a third SC resistor member (440),
f) a fourth SC resistor member (445),
g) a first filter capacitor (420),
h) a second filter capacitor (430),
i) a third filter capacitor (435),
j) the non-inverting input of the second operational amplifier (OP4) and the non-inverting input of the third operational amplifier (OP5) being at a reference potential,
k) the input of the filter module (115) being connected via the first SC resistor member (425) to the inverting input of the second operational amplifier (OP4),
l) the output of the filter module (115) being connected to the output of the third operational amplifier (OP5),
m) the inverting input of the third operational amplifier (OP5) being connected via the second filter capacitor (430) to the input of the filter module (115),
n) the output of the second operational amplifier (OP4) being connected via the first filter capacitor (420) to the inverting input of the second operational amplifier (OP4),
o) the output of the second operational amplifier (OP4) being connected via the second SC resistor member (425) to the inverting input of the third operational amplifier (OP5),
p) the inverting input of the third operational amplifier (OP5) being connected via the third SC resistor member (440) to the output of the third operational amplifier (OP5),
q) the inverting input of the second operational amplifier (OP4) being connected via the fourth SC resistor member (445) to the output of the third operational amplifier (OP5), and
r) the inverting input of the third operational amplifier (OP5) being connected via the third filter capacitor (435) to the output of the third operational amplifier (OP5).

6. The filter circuit of any of claims 1 to 3,
**characterized in that** the filter module (115) comprises:
a) first, second and third capacitors (505, 515 and 525, respectively),
b) first and second resistors (510 and 520, respectively),
c) an SC resistor member (540, 545, 550),
d) the input (IN) of the filter module (115) being connected via the first capacitor (505) to the output (OUT) of the filter module (115),
e) the input (IN) of the filter module (115) being connected via the first resistor (510) and the second capacitor (515) to the reference potential,
f) the output (OUT) of the filter module (115) being connected via the second resistor (520) and the third capacitor (525) to the reference potential,
g) the circuit node between the first resistor (510) and the second capacitor (515) being connected via the SC resistor member (540, 545, 550) to the circuit node between the second resistor (520) and the third capacitor (525).

7. The filter circuit of claim 6,
**characterized in that** the SC resistor member (530) comprises a switched capacitor (540), a first switching means (545) and a second switching means (550), the first switching means (545), in the conducting state, discharging the switched capacitor (540), and the second switching means (550), in the non-conducting state, electrically separating a terminal of the switched capacitor (540) from the surroundings.

8. The filter circuit of any of claims 1 to 3,
**characterized in that** the filter module (115) comprises:
a) a second operational amplifier (OP2),
b) a third operational amplifier (OP3),
c) a first SC resistor member (310),
d) a second SC resistor member (325),
e) a third SC resistor member (335),
f) a fourth SC resistor member (340),
g) a first filter capacitor (320),
h) a second filter capacitor (330),
i) the non-inverting input of the second operational amplifier (OP2) and the non-inverting input of the third operational amplifier (OP3) being at a reference potential,
j) the input (IN) of the filter module (115) being connected via the first SC resistor member (310) to the inverting input of the second operational amplifier (OP2),
k) the output of the second operational amplifier (OP2) being connected via the second SC resistor member (325) to the inverting input of the third operational amplifier (OP3),
l) the output (OUT) of the third operational amplifier (OP3) being connected to the output of the filter module (115),
m) the output of the second operational amplifier (OP2) being connected via the first filter capacitor (320) to the inverting input of the second operational amplifier (OP2),
n) the output of the third operational amplifier (OP3) being connected via the second filter capacitor (330) to the inverting input of the third operational amplifier (OP3),
o) the output of the third operational amplifier (OP3) being connected via the third SC resistor member (335) to the inverting input of the third operational amplifier (OP3), and
p) the output of the third operational amplifier (OP3) being connected via the fourth SC resistor member (340) to the inverting input of the second operational amplifier (OP2).

9. An audio signal processor comprising
a) at least one audio signal input and at least one audio signal output as well as at least one control input, and
b) an audio signal processing unit connected between audio signal input and audio signal output,
**characterized in that**
c) the audio signal processing unit comprises at least one filter circuit according to any one of claims 1 to 8.

10. The audio signal processor of claim 9,
**characterized by**
a) a digital control unit connectable to a data bus line,
b) said digital control unit determining the setting of said ohmic voltage divider (105).

## Revendications

1. Circuit de filtre pour l'abaissement ou l'augmentation réglables de l'amplitude de signaux audio dans une plage de fréquences prédéterminée,
a) avec une entrée (IN) et une sortie (OUT),
b) avec un premier amplificateur opérationel (OP1), l'entrée non inverseuse du premier amplificateur opérationel (OP1) étant reliée à l'entrée (IN),
c) avec un diviseur de tension ohmique (110) servant de dispositif de réglage, dont le curseur (105) est relié à l'entrée inverseuse du premier amplificateur opérationel (OP1) et dont la première prise de l'extrémité est reliée à la sortie du premier amplificateur opérationel (OP1),
d) avec un module de filtre (115), le module de filtre présentant un réseau avec au moins un élément RC déterminant la courbe de fréquence, dont la composante de résistance R est réalisée selon la technique SC,
e) l'entrée du module de filtre (115) étant reliée à la sortie du premier amplificateur opérationel (OP1), et
f) la sortie du module de filtre (115) étant reliée directement à une deuxième prise d'extrémité du diviseur de tension ohmique (110).

2. Circuit de filtre selon la revendication 1, **caractérisé en ce que** le dispositif de réglage (110) présente un potentiomètre.

3. Circuit de filtre selon la revendication 1, **caractérisé en ce que** le dispositif de réglage (110) est pourvu d'un diviseur de tension présentant un ou plusieurs transistors.

4. Circuit de filtre selon l'une des revendications précédentes, **caractérisé en ce que** le module de filtre (115) présente un filtre biquadratique.

5. Circuit de filtre selon la revendication 4, **caractérisé en ce que** le module de filtre (115) présente :
a) un deuxième amplificateur opérationel (OP4),
b) un troisième amplificateur opérationel (OP5),
c) un premier élément de résistance SC (405),
d) un deuxième élément de résistance SC (425),
e) un troisième élément de résistance SC (440),
f) un quatrième élément de résistance SC (445),
g) une première capacité de filtre (420),
h) une deuxième capacité de filtre (430),
i) une troisième capacité de filtre (435),
j) l'entrée non inverseuse du deuxième amplificateur opérationel (OP4) ainsi que l'entrée non inverseuse du troisième amplificateur opérationel (OP5) étant mises à un potentiel de référence,
k) l'entrée du module de filtre (115) étant reliée par l'intermédiaire du premier élément de résistance SC (405) à l'entrée inverseuse du deuxième amplificateur opérationel (OP4),
l) la sortie du module de filtre (115) étant reliée à la sortie du troisième amplificateur opérationel (OP5),
m) l'entrée inverseuse du troisième amplificateur opérationel (OP5) étant reliée par l'intermédiaire de la deuxième capacité de filtre (430) à l'entrée du module de filtre (115),
n) la sortie du deuxième amplificateur opérationel (OP4) étant reliée par l'intermédiaire de la première capacité de filtre (420) à l'entrée inverseuse du deuxième amplificateur opérationel (OP4),
o) la sortie du deuxième amplificateur opérationel (OP4) étant reliée par l'intermédiaire du deuxième élément de résistance SC (425) à l'entrée inverseuse du troisième amplificateur opérationel (OP5),
p) l'entrée inverseuse du troisième amplificateur opérationel (OP5) étant reliée par l'intermédiaire du troisième élément de résistance SC (440) à la sortie du troisième amplificateur opérationel (OP5),
q) l'entrée inverseuse du deuxième amplificateur opérationel (OP4) étant reliée par l'intermédiaire du quatrième élément de résistance SC (445) à la sortie du troisième amplificateur opérationel (OP5), et
r) l'entrée inverseuse du troisième amplificateur opérationel (OP5) étant reliée par l'intermédiaire de la troisième capacité de filtre (435) à la sortie du troisième amplificateur opérationel (OP5).

6. Circuit de filtre selon l'une des revendications 1 à 3, **caractérisé en ce que** le module de filtre (115) présente :
a) une première, une deuxième et une troisième capacités (505, 515 ou 525),
b) une première et une deuxième résistances (510 ou 520),
c) un élément de résistance SC (540, 545, 550),
d) l'entrée (IN) du module de filtre (115) étant reliée par l'intermédiaire de la première capacité (505) à la sortie (OUT) du module de filtre (115),
e) l'entrée (IN) du module de filtre (115) étant reliée par l'intermédiaire de la première résistance (510) et la deuxième capacité (515) au potentiel de référence,
f) la sortie (OUT) du module de filtre (115) étant reliée par l'intermédiaire de la deuxième résistance (520) et la troisième capacité (525) au potentiel de référence,
g) le noeud de couplage entre la première résistance (510) et la deuxième capacité (515) étant relié par l'intermédiaire de l'élément de résistance SC (540, 545, 550) au noeud de couplage entre la deuxième résistance (520) et la troisième capacité (525).

7. Circuit de filtre selon la revendication 6, **caractérisé en ce que** l'élément de résistance SC (530) présente un condensateur (540) couplé, un premier dispositif de couplage (545) et un deuxième dispositif de couplage (550), le premier dispositif de couplage (545) déchargeant, à l'état conducteur, le condensateur (540) couplé, et le deuxième dispositif de couplage (550) séparant électriquement de l'environnement, à état non conducteur, un contact du condensateur (540) couplé.

8. Circuit de filtre selon l'une des revendications 1 à 3, **caractérisé en ce que** le module de filtre (115) présente :
a) un deuxième amplificateur opérationel (OP2),
b) un troisième amplificateur opérationel (OP3),
c) un premier élément de résistance SC (310),
d) un deuxième élément de résistance SC (325),
e) un troisième élément de résistance SC (335),
f) un quatrième élément de résistance SC (340),
g) une première capacité de filtre (320),
h) une deuxième capacité de filtre (330),
i) l'entrée non inverseuse du deuxième amplificateur opérationel (OP2) ainsi que l'entrée non inverseuse du troisième amplificateur opérationel (OP3) étant mises à un potentiel de référence,
j) l'entrée (IN) du module de filtre (115) étant reliée par l'intermédiaire du premier élément de résistance SC (310) à l'entrée inverseuse du deuxième amplificateur opérationel (OP2),
k) la sortie du deuxième amplificateur opérationel (OP2) étant reliée par l'intermédiaire du deuxième élément de résistance SC (325) à l'entrée inverseuse du troisième amplificateur opérationel (OP3),
l) la sortie (OUT) du troisième amplificateur opérationel (OP3) étant reliée à la sortie du module de filtre (115),
m) la sortie du deuxième amplificateur opérationel (OP2) étant reliée par l'intermédiaire de la première capacité de filtre (320) à l'entrée inverseuse du deuxième amplificateur opérationel (OP2),
n) la sortie du troisième amplificateur opérationel (OP3) étant reliée par l'intermédiaire de la deuxième capacité de filtre (330) à l'entrée inverseuse du troisième amplificateur opérationel (OP3),
o) la sortie du troisième amplificateur opérationel (OP3) étant reliée par l'intermédiaire du troisième élément de résistance SC (335) à l'entrée inverseuse du troisième amplificateur opérationel (OP3), et
p) la sortie du troisième amplificateur opérationel (OP3) étant reliée par l'intermédiaire du quatrième élément de résistance SC (340) à l'entrée inverseuse du deuxième amplificateur opérationel (OP2).

9. Processeur à signaux audio comprenant
a) au moins une entrée de signaux audio et au moins une sortie de signaux audio ainsi qu'au moins une entrée de commande, et
b) une unité de traitement de signaux audio couplée entre l'entrée de signaux audio et la sortie de signaux audio,
**caractérisé en ce que**
c) l'unité de traitement de signaux audio présente au moins un circuit de filtre selon l'une des revendications 1 à 8.

10. Processeur à signaux audio selon la revendication 9, **caractérisé par**
a) une unité de commande numérique pouvant être reliée à une ligne collectrice de données,
b) l'unité de commande numérique déterminant le réglage du diviseur de tension ohmique (105).
